# EUROPÄISCHE PATENTSCHRIFT

(11) **EP 3 433 395 B1**
(45) Veröffentlichungstag und Bekanntmachung des Hinweises auf die Patenterteilung: **29.04.2020**
(21) Anmeldenummer: 17714654.5
(22) Anmeldetag: 16.03.2017
(51) Int. Cl.: C23C 16/04, C23C 16/44, C23C 16/511, C23C 16/54, C23C 16/455, C23C 16/52, H01J 37/32

(54) **VERFAHREN UND VORRICHTUNG ZUR PLASMABEHANDLUNG VON BEHÄLTERN**
METHOD AND DEVICE FOR PLASMA TREATMENT OF CONTAINERS
PROCÉDÉ ET DISPOSITIF DE TRAITEMENT PAR PLASMA DE RÉCIPIENTS

(30) Priorität: 24.03.2016 DE 102016105548
(43) Veröffentlichungstag der Anmeldung: 30.01.2019
(73) Patentinhaber: KHS Corpoplast GmbH, 22145 Hamburg (DE)
(72) Erfinder: DISTERHOF, Alexander, 21033 Hamburg (DE); HERBORT, Michael, 20535 Hamburg (DE); KYTZIA, Sebastian, 23826 Todesfelde (DE)
(74) Vertreter: DTS Patent- und Rechtsanwälte Schnekenbühl und Partner mbB
(86) Internationale Anmeldenummer: PCT/EP2017/056223
(87) Internationale Veröffentlichungsnummer: WO 2017/162509

(56) Entgegenhaltungen:
- WO-A1-95/22413
- DE-A1- 10 225 609
- US-A1- 2002 192 369
- US-A1- 2013 041 241

## Beschreibung

Die Erfindung bezieht sich auf ein Verfahren zur Plasmabehandlung von Behältern gemäß dem Oberbegriff des Patentanspruches 1. Die Erfindung betrifft weiterhin eine Vorrichtung zur Plasmabehandlung von Behältern gemäß dem Oberbegriff des Patentanspruches 11.

Derartige Verfahren und Vorrichtungen werden beispielsweise eingesetzt, um Kunststoffe mit Oberflächenbeschichtungen zu versehen. Insbesondere sind auch bereits derartige Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der Druckschrift WO95/22413 A1 wird eine Plasmakammer zur Innenbeschichtung von Behältern aus PET beschrieben. Die zu beschichtenden Behälter werden durch einen beweglichen Boden in eine Plasmakammer hineingehoben und im Bereich einer Behältermündung mit einem Adapter in Verbindung gebracht. Durch den Adapter hindurch kann eine Evakuierung des Behälterinnenraumes erfolgen. Darüber hinaus wird durch den Adapter hindurch eine hohle Gaslanze in den Innenraum der Behälter eingeführt, um Prozessgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Behältern je Zeiteinheit unterstützt.

In der Druckschrift EP 10 10 773 A1 wird eine Zuführeinrichtung erläutert, um einen Flascheninnenraum zu evakuieren und mit Prozessgas zu versorgen. In der WO 01/31680 A1 wird eine Plasmakammer beschrieben, in die die Flaschen von einem beweglichen Deckel eingeführt werden, der zuvor mit einem Mündungsbereich der Flaschen verbunden wurde.

Die Druckschrift WO 00/58631 A1 zeigt ebenfalls bereits die Anordnung von Plasmastationen auf einem rotierenden Rad und beschreibt für eine derartige Anordnung eine gruppenweise Zuordnung von Unterdruckstufen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kammer erwähnt.

Eine weitere Anordnung zur Durchführung einer Innenbeschichtung von Flaschen wird in der Druckschrift WO 99/17334 A1 beschrieben. Es wird hier insbesondere eine Anordnung eines Mikrowellengenerators oberhalb der Plasmakammer sowie eine Vakuum- und Betriebsmittelzuleitung durch einen Boden der Plasmakammer hindurch beschrieben.

In der DE 10 2004 020 185 A1 wird bereits eine Gaslanze beschrieben, die in den Innenraum eines zu beschichtenden Vorformlings einfahrbar ist und zur Zuleitung von Prozessgasen dient. Die Gaslanze ist in der Längsrichtung des Behälters positionierbar. Weiterhin wird in DE10225609 A1 ein Verfahren und eine Vorrichtung zur Plasmabehandlung von Behälter offenbart, wobei die Behandlung mittels eines mehrere Plasmastationen an einem Plasmarad aufweisenden Plasmamoduls unter Zuleitung von Prozessgasen statt findet.

Bei der überwiegenden Anzahl der bekannten Vorrichtungen werden zur Verbesserung von Barriereeigenschaften des thermoplastischen Kunststoffmaterials durch das Plasma erzeugte Behälterschichten aus Siliziumoxiden mit der allgemeinen chemischen Formel SiOx verwendet. Derartige Barriereschichten insbesondere an der Innenwandung eines Behälterinnenraums verhindern ein Eindringen von Sauerstoff in die verpackten Flüssigkeiten sowie ein Austreten von Kohlendioxid bei CO2-haltigen Flüssigkeiten und verbessern damit die Lagerungseigenschaften bzw. die dauerhafte Haltbarkeitsmachung der in dem Behälter abgefüllten und/oder verpackten Flüssigkeiten.

In einem üblichen Vorrichtungsaufbau zur Plasmabehandlung sind auf einem Plasmarad in entsprechenden Winkelabschnitten n-Behandlungssegmente angeordnet, wobei jedes Behandlungssegment eine Plasmastation mit mindestens einer oder mehreren evakuierbaren Plasmakammer mit einer oder mehreren Behandlungsplätzen zur Behälterbehandlung umfasst. In jeder Plasmakammer bzw. dem Kammerinnenraum sind beispielsweise zwei oder vier Behandlungsplätze angeordnet, so dass auf einem Plasmarad insgesamt für die vorgenannten Bauformen folglich n mal 2 oder n mal 4 Behandlungsplätze umlaufen.

Die eine oder die mehreren Behälter werden bei geöffneter Plasmakammer eines Behandlungssegmentes in einem Belade- oder einem Entnahmeschritt gemeinsam zuoder ausgeleitet, wobei diese für die einzelnen Behälter zeitgleich oder geringfügig zeitlich versetzt erfolgen kann. In der Regel ist in einem Behandlungssegment eine Plasmastation als Baueinheit vorgesehen, so dass in einem Belade- oder einem Entnahmeschritt alle Behälter einer Plasmastation in analoger Weise gemeinsam zuoder ausgeleitet werden. Somit umfasst in der einfachsten Bauweise ein Behandlungssegment eine Plasmastation mit einer Plasmakammer, die einen Kammerinnenraum aufweist, in der ein Behandlungsplatz für einen Behälter angeordnet ist.

Üblicherweise wird bei den bekannten Verfahren und Vorrichtungen zur Plasmabehandlung das in die Plasmakammer einer entsprechenden Plasmastation eingeschleuste Prozessgas über eine zentrale Prozessgasversorgungseinheit bereitgestellt, die mit sämtlichen, an einem Plasmarad des Plasmamoduls angeordneten Plasmastationen bzw. deren Behandlungsplätzen zusammenwirkt. Kommt es dabei zu einer Betriebsstörung, d. h. insbesondere einem Ausfall, an einer oder mehreren Plasmastationen oder Behandlungsplätzen des Plasmamoduls, so wird im Stand der Technik das für diese entsprechende Plasmastation bereitgestellte Prozessgas auf die übrigen, intakten Plasmastationen des Plasmamoduls verteilt. Dies wiederum führt zu einem unerwünschten Mehrdurchsatz von Prozessgas an den übrigen, intakten und damit keiner Betriebsstörung unterliegenden Plasmastationen und damit letztlich zu einer negativen Beeinflussung der Qualität der Barriereschichten an der Innenwandung der Behälter.

Aufgabe der Erfindung ist es, ein Verfahren und eine Vorrichtung zur Plasmabehandlung von Behältern anzugeben, das selbst bei einer Betriebsstörung, d. h. insbesondere einem Ausfall, wenigstens einer Plasmastation an den übrigen intakten Plasmastationen eine gleichbleibende Qualität der Barriereschicht an der Innenwandung der Behälter bereitstellt. Zur Lösung dieser Aufgabe ist ein Verfahren zur Plasmabehandlung von Werkstücken entsprechend dem Patentanspruch 1 ausgebildet. Eine Vorrichtung zur Plasmabehandlung von Behältern bildet den Gegenstand des Patentanspruches 11.

Der wesentliche Aspekt des erfindungsgemäßen Verfahrens besteht darin, dass bei einer Betriebsstörung oder Ausblendung, d.h. gezielte Abschaltung wenigstens eines Behandlungsplatzes und/oder einer Plasmastation o, das Prozessgas vor dessen Zuführung zum Behandlungsplatz und/oder in die Plasmastation mittels einer Bypassleitung abgeleitet wird. Dabei wird das erfindungsgemäße Verfahren an einem mehrere Behandlungssegmente an einem Plasmarad aufweisenden Plasmamodul mit je einem oder mehreren Plasmastationen durchgeführt, bei welchem das zumindest teilweises Beaufschlagen des Behälterinnenraums oder der Behälterinnenräume innerhalb der zumindest teilweise evakuierten Plasmakammer mit einem Prozessgas erfolgt, insbesondere an zumindest zwei Plasmastationen gleichzeitig erfolgt. Jede Plasmastation umfasst dabei mindestens einen Behandlungsplatz für je einen Behälter. Besonders vorteilhaft wird damit das an einem defekten Behandlungsplatz oder einer defekten Plasmastation unverwertbare Prozessgas nicht mehr, wie im Stand der Technik üblich, an eine weitere, an dem Plasmarad angeordnete und intakt arbeitende Plasmastation verteilt. Es wird stattdessen erfindungsgemäß vor der Zuführung an den ausgeblendeten oder eine Betriebsstörung aufweisenden Behandlungsplatz und/oder die Plasmastation mittels einer oder mehreren Bypassleitungen abgeleitet bzw. abgeführt. Mithin wird hierdurch ein Mehrdurchsatz an Prozessgas an den intakt arbeitenden und in den Beschichtungsprozess regulär eingegliederten Behandlungsplätzen und Plasmastationen verhindert, da die für die defekte Plasmastation vorbestimmte Menge an Prozessgas nicht auf die übrigen Plasmastationen bzw. die Behandlungsplätze verteilt, sondern abgeleitet wird.

Eine permanente Ausblendung einer Plasmastation oder mindestens eines ihrer Behandlungsplätze erfolgt beispielsweise dann, wenn diese einen Fehler oder eine Funktionsstörung hat. Hierdurch kann die Ausschussrate an Behältern reduziert werden, bis die Plasmastation repariert oder ausgetauscht werden kann. Nachfolgende wird zur Vereinfachung häufig nur noch von Plasmastationen, Ausblendung und Betriebsstörung gesprochen, auch wenn nur einzelnen Behandlungsplätze einer Plasmastation betroffen sind, wenn beispielsweise nur eine Teilbetriebsstörung oder Teilausblendung einer Plasmastation vorliegt. In diesem Fall wird erfindungsgemäß nur ein Behandlungsplatz oder einzelne Behandlungsplätze einer Plasmastation bzw. einer Plasmakammer inaktiviert bzw. ist die Vorrichtung hierfür ausgelegt und geeignet. Dies ist bei allen nachfolgenden Ausführungen und Ausführungsvarianten immer in analoger Weise für das erfindungsgemäße Verfahren und die Vorrichtung zu verstehen.

Weiterhin erfolgt eine temporäre Ausblendung von einer oder mehreren Plasmastationen, wenn vakuumtechnische Anfahrschwierigkeiten vorliegen. Bei nicht hinreichender Vakuumqualität kann es nötig sein, dass bei hohen Anlagengeschwindigkeiten die ersten Flaschen der Plasmastationen ausgeschleust werden müssen. Durch gezieltes, automatisches Ausblendung der vorgeschalteten Plasmastationen beim Anfahren, kann ein größerer Unterdruck erzeugt werden. Das Ausschleusen von Behälter wird vermieden oder zumindest verringert werden, weil hierdurch ein hinreichende Vakuumqualität unmittelbar bei den ersten zu beschichtenden Behältern erreicht wird, so dass die Ausschussrate reduziert wird.

Ebenfalls wird bei einer Fehlbeladung der Bypass aktiviert, dies sind Situationen, bei welchen kein Behälter in einer Plasmastation vorliegt oder diese nicht korrekt in ihrer Halterung gehalten wird. Schlussendlich werden Ausblendungen und die Aktivierung von Bypassströmen auch gezielt eingesetzt, um systematisch Fehler zu suchen. Diese Option verbessert also die Reparatur- und Servicefreundlichkeit. Nachfolgende soll unter einer Betriebsstörung immer auch der Fall einer ausgeblendeten Plasmastation verstanden werden, weil als Normalfall eine vollständige Beladung und Nutzung aller Plasmastationen eines Plasmarades anzusehen ist, so dass auch ein gesteuertes Ausblenden eine gewisse Betriebsstörung darstellt.

Natürlich sind von der Erfindung auch die Fälle umfasst, bei welchen eine oder mehrere Plasmakammer inaktiviert werden, also alle Plasmastation deren Plasmakammern ausgeblendet werden oder eine Betriebsstörung aufweisen.

In einer vorteilhaften Ausführungsvariante kann an der wenigstens einen, eine Betriebsstörung aufweisenden Plasmastation eine Prozessgasmenge abgeleitet werden, die der für diese Plasmastation im intakt arbeitenden Betrieb vorbestimmten Prozessgasmenge entspricht.

In einer weiteren vorteilhaften Ausführungsvariante kann das Prozessgas in der Bypassleitung mittels zumindest einer Ventileinrichtung und/oder einer Drosseleinrichtung geregelt und/oder gesteuert abgeleitet werden.

In einer nochmals vorteilhaften weiteren Ausführungsvariante kann mittels der Drosseleinrichtung der Volumenstrom des abgeleiteten Prozessgases in der Bypassleitung geregelt und/oder gesteuert abgeleitet werden.

In einer wiederum weiteren vorteilhaften Ausführungsvariante kann die Drosseleinrichtung der Bypassleitung der wenigstens einen, eine Betriebsstörung aufweisenden Plasmastation derart gesteuert und/oder geregelt werden, dass der über die Bypassleitung abgeleitete Volumenstrom an Prozessgas dem Volumenstrom an Prozessgas entspricht, mit dem die wenigstens eine, eine Betriebsstörung aufweisende Plasmastation über eine oder mehrere einer ersten bis dritten Ventileinrichtungen beaufschlagt wird.

Vorteilhafterweise kann zu dem Zeitpunkt des Öffnens einer oder mehrerer der ersten bis dritten Ventileinrichtungen der wenigstens einen, eine Betriebsstörung aufweisenden Plasmakammer zeitgleich oder zeitlich kurz vorgelagert die Ventileinrichtung geöffnet und das Prozessgas über die Bypassleitung abgeleitet werden.

Wiederum bevorzugt kann das Prozessgas in einer vorbestimmten Prozessgasmenge und/oder zeitlichen Taktung an die zumindest eine, eine Betriebsstörung aufweisende Plasmastation über eine oder mehrere Prozessgasleitungen einer zentralen Prozessgasversorgungseinheit geleitet werden.

In einer wiederum weiteren vorteilhaften Ausführungsvariante kann das Prozessgas der zumindest einen, eine Betriebsstörung aufweisenden Plasmastation mittels der Bypassleitung in eine zentrale Vakuumeinrichtung abgeleitet werden und zwar bevorzugt in eine Vakuumleitung mit der niedrigsten Unterdruckstufe der zentralen Vakuumeinrichtung.

Unter "Betriebsstörung" wird im Rahmen der vorliegenden Erfindung die Außerbetriebnahme, also beispielsweise der technische Ausfall, insbesondere einer Plasmastation verstanden, so dass an dieser Plasmastation mit Betriebsstörung keine Plasmabehandlung von Behältern stattfinden kann.

Unter "Behälter" werden im Rahmen der Erfindung insbesondere Dosen, Flaschen, Fässer, auch KEGs, Tuben, Pouches, jeweils aus Metall, Glas und/oder Kunststoff, verstanden, aber auch andere Packmittel, insbesondere auch solche die zum Abfüllen von pulverförmigen, granulatartigen, flüssigen oder viskosen Produkten geeignet sind. Der Ausdruck "im Wesentlichen" bzw. "etwa" bzw. "ca." bedeutet im Sinne der Erfindung Abweichungen vom jeweils exakten Wert um +/- 10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

Die Erfindung wird im Folgenden anhand der Figuren an Ausführungsbeispielen näher erläutert. Es zeigen:
- Fig. 1: eine Prinzipskizze einer Mehrzahl von Plasmakammern, die auf einem rotierenden Plasmarad angeordnet sind und bei der das Plasmarad mit Eingabe- und Ausgaberädern gekoppelt ist,
- Fig. 2: eine Anordnung gemäß Fig. 1, bei der die Plasmastationen jeweils zwei Plasmakammern aufweisen,
- Fig. 3: eine perspektivische Darstellung eines Plasmarades mit einer Vielzahl von Plasmakammern,
- Fig. 4: eine perspektivische Darstellung einer Plasmastation mit einer Plasmakammer,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: ein schematisches Blockschaltbild einer erfindungsgemäß ausgebildeten Plasmastation.

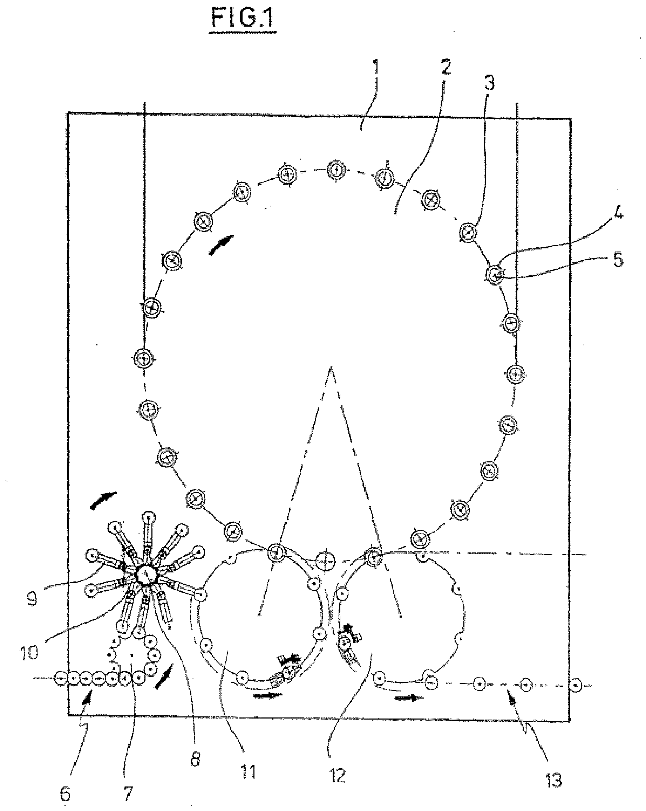

In Figur 1 ist mit dem Bezugszeichen 1 allgemein ein Plasmamodul bezeichnet, das mit einem rotierenden Plasmarad 2 versehen ist. Entlang eines Umfanges des Plasmarades 2 befinden sich eine Mehrzahl von gleichartig aufgebauten Plasmastationen 3 angeordnet. Die Plasmastationen 3 sind mit Kammerinnenräumen 4 bzw. Plasmakammern 17 zur Aufnahme von zu behandelnden Behältern 5 mit jeweils zumindest einem Behälterinnenraum 5.1 versehen.

Die zu behandelnden Behälter 5 werden dem Plasmamodul 1 im Bereich einer Eingabe 6 zugeführt und über ein Vereinzelungsrad 7 an ein Übergaberad 8 weitergeleitet, das mit positionierbaren Tragarmen 9 ausgestattet ist. Die Tragarme 9 sind relativ zu einem Sockel 10 des Übergaberades 8 verschwenkbar angeordnet, so dass eine Abstandsveränderung der Behälter 5 relativ zueinander durchgeführt werden kann. Hierdurch erfolgt eine Übergabe der Behälter 5 vom Übergaberad 8 an ein Eingaberad 11 mit einem relativ zum Vereinzelungsrad 7 vergrößerten Abstand der Behälter 5 relativ zueinander. Das Eingaberad 11 übergibt die zu behandelnden Behälter 5 an das Plasmarad 2. Nach einer Durchführung der Behandlung werden die behandelten Behälter 5 von einem Ausgaberad 12 aus dem Bereich des Plasmarades 2 entfernt und in den Bereich einer Ausgabestrecke 13 überführt.

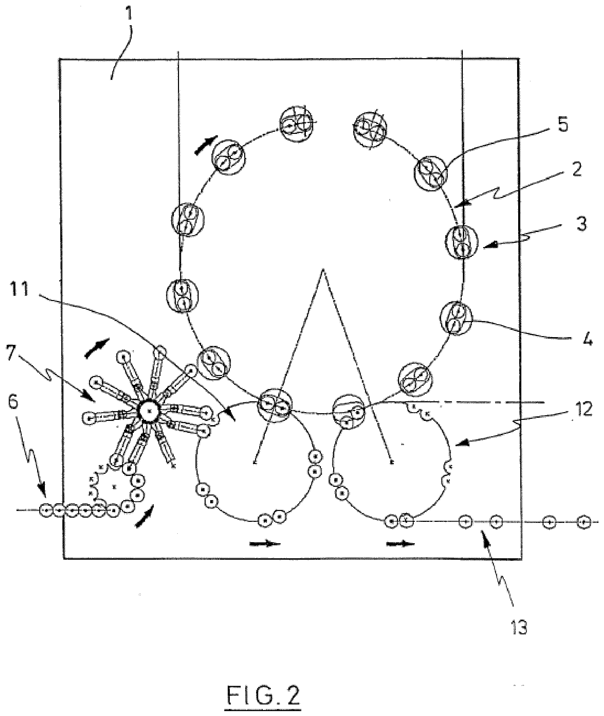

Bei der Ausführungsform gemäß Figur 2 sind die Plasmastationen 3 jeweils mit zwei Behandlungsplätzen (40) und zugehörigen Kammerinnenräumen 4 bzw. Plasmakammern 17 ausgestattet. Hierdurch können jeweils zwei Behälter 5 gleichzeitig behandelt werden. Grundsätzlich ist es hierbei möglich, die Kammerinnenräume4 vollständig voneinander getrennt auszubilden, grundsätzlich ist es aber auch möglich, in einem gemeinsamen Kammerinnenraum lediglich Teilbereiche derart abzugrenzen, dass eine optimale Beschichtung aller Behälter 5 gewährleistet ist. Insbesondere ist hierbei daran gedacht, die Teilkammerinnenräume zumindest durch separate Mikrowelleneinkopplungen gegeneinander abzugrenzen.

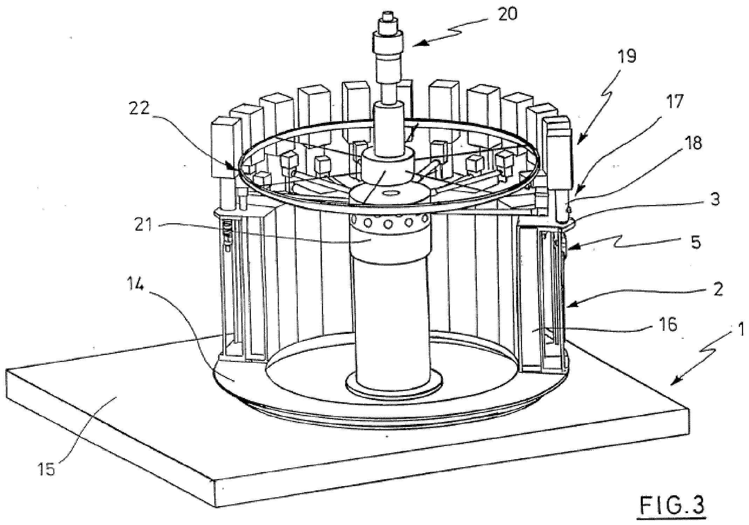

Figur 3 zeigt eine perspektivische Darstellung eines Plasmamoduls 1 mit teilweise aufgebautem Plasmarad 2. Die Plasmastationen 3 sind auf einem Tragring 14 angeordnet, der als Teil einer Drehverbindung ausgebildet und im Bereich eines Maschinensockels 15 gelagert ist. Die Plasmastationen 3 weisen jeweils einen Stationsrahmen 16 auf, der die Plasmakammern 17 haltert.

Die Plasmakammern 17 können zylinderförmige Kammerwandungen 18 sowie Mikrowellengeneratoren 19 aufweisen.

In einem Zentrum des Plasmarades 2 kann ein Drehverteiler 20 vorgesehen sein, über den die Plasmastationen 3 mit Betriebsmitteln, wie beispielsweise Prozessgas, sowie Energie versorgt werden. Insbesondere kann der Drehverteiler 20 mit einer zentralen Prozessgasversorgungseinheit zusammenwirken. Zur Betriebsmittelverteilung an dem Plasmarad 2 können insbesondere Ringleitungen 21 eingesetzt bzw. angesetzt werden.

Die zu behandelnden Behälter 5 sind unterhalb der zylinderförmigen Kammerwandungen 18 dargestellt, wobei Unterteile der Plasmakammern 17 zur Vereinfachung jeweils nicht eingezeichnet sind.

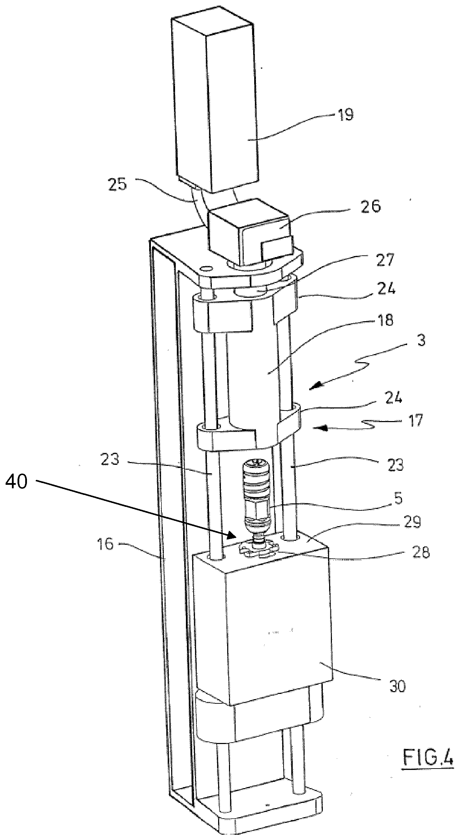

Figur 4 zeigt eine Plasmastation 3 in perspektivischer Darstellung mit einem Behandlungsplatz 40 für einen Behälter 5. Es ist zu erkennen, dass der Stationsrahmen 16 mit Führungsstangen 23 versehen ist, auf denen ein Schlitten 24 zur Halterung der zylinderförmigen Kammerwandung 18 geführt ist. Figur 4 zeigt den Schlitten 24 mit Kammerwandung 18 in einem angehobenen Zustand, so dass der Behälter 5 freigegeben ist.

Im oberen Bereich der Plasmastation 3 ist der Mikrowellengenerator 19 angeordnet. Der Mikrowellengenerator 19 ist über eine Umlenkung 25 und einen Adapter 26 an einen Kopplungskanal 27 angeschlossen, der in die Plasmakammer 17 einmündet. Grundsätzlich kann der Mikrowellengenerator 19 sowohl unmittelbar im Bereich des Kammerdeckels 31 als auch über ein Distanzelement an den Kammerdeckel 31 angekoppelt mit einer vorgebbaren Entfernung zum Kammerdeckel 31 und somit in einem größeren Umgebungsbereich des Kammerdeckels 31 angeordnet werden. Der Adapter 26 hat die Funktion eines Übergangselementes und der Kopplungskanal 27 ist als ein Koaxialleiter ausgebildet. Im Bereich einer Einmündung des Kopplungskanals 27 in den Kammerdeckel 31 ist ein Quarzglasfenster angeordnet. Die Umlenkung 25 ist als ein Hohlleiter ausgebildet.

Der Behälter 5 wird von einem Halteelement 28 an dem Behandlungsplatz 40 positioniert, das im Bereich eines Kammerbodens 29 angeordnet ist. Der Kammerboden 29 ist als Teil eines Kammersockels 30 ausgebildet. Zur Erleichterung einer Justage ist es möglich, den Kammersockel 30 im Bereich der Führungsstangen 23 zu fixieren. Eine andere Variante besteht darin, den Kammersockel 30 direkt am Stationsrahmen 16 zu befestigen. Bei einer derartigen Anordnung ist es beispielsweise auch möglich, die Führungsstangen 23 in vertikaler Richtung zweiteilig auszuführen.

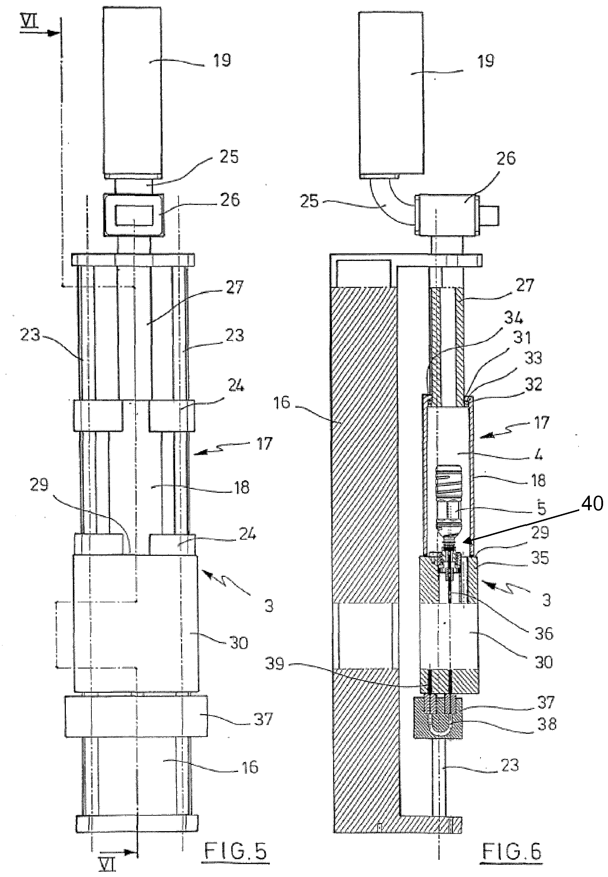

Figur 5 zeigt eine Vorderansicht der Plasmastation 3 gemäß Figur 3 und Figur 4 in einem geschlossenen Zustand der Plasmakammer 17. Der Schlitten 24 mit der zylinderförmigen Kammerwandung 18 ist hierbei gegenüber der Positionierung in Figur 4 abgesenkt, so dass die Kammerwandung 18 gegen den Kammerboden 29 gefahren ist. In diesem Positionierzustand kann die Plasmabeschichtung durchgeführt werden.

Figur 6 zeigt in einer Vertikalschnittdarstellung die Anordnung gemäß Figur 5. Es ist insbesondere zu erkennen, dass der Kopplungskanal 27 in einen Kammerdeckel 31 einmündet, der einen seitlich überstehenden Flansch 32 aufweist. Im Bereich des Flansches 32 ist eine Dichtung 33 angeordnet, die von einem Innenflansch 34 der Kammerwandung 18 beaufschlagt wird. In einem abgesenkten Zustand der Kammerwandung 18 erfolgt hierdurch eine Abdichtung der Kammerwandung 18 relativ zum Kammerdeckel 31. Eine weitere Dichtung 35 ist in einem unteren Bereich der Kammerwandung 18 angeordnet, um auch hier eine Abdichtung relativ zum Kammerboden 29 zu gewährleisten.

In der in Figur 6 dargestellten Positionierung umschließt die Kammerwandung 18 den Kammerinnenraum 4, so dass sowohl der Kammerinnenraum 4 als auch ein Behälterinnenraum 5.1 des Behälters 5 evakuiert werden können. Zur Unterstützung einer Zuleitung von Prozessgas ist im Bereich des Kammersockels 30 eine hohle Gaslanze 36 angeordnet, die in den Behälterinnenraum 5.1 des Behälters 5 hinein verfahrbar ist. Zur Durchführung einer Positionierung der Gaslanze 36 wird diese von einem Lanzenschlitten 37 gehaltert, der entlang der Führungsstangen 23 positionierbar ist. Innerhalb des Lanzenschlittens 37 verläuft ein Prozessgaskanal 38, der in der in Figur 6 dargestellten angehobenen Positionierung mit einem Gasanschluss 39 des Kammersockels 30 gekoppelt ist. Durch diese Anordnung werden schlauchartige Verbindungselemente am Lanzenschlitten 37 vermieden. Im in den Behälterinnenraum 5.1 eingefahrenen Zustand der Gaslanze 36 ist der Behälterinnenraum 5.1 des Behälters 5 gegenüber dem Kammerinnenraum 4 isoliert, d. h. abgedichtet. Wohingegen in einem abgesenkten Zustand der Gaslanze 36 eine gasdurchlässige Verbindung zwischen dem Behälterinnenraum 5.1 des Behälters 5 und der Kammerinnenraum 4 geschaffen wird.

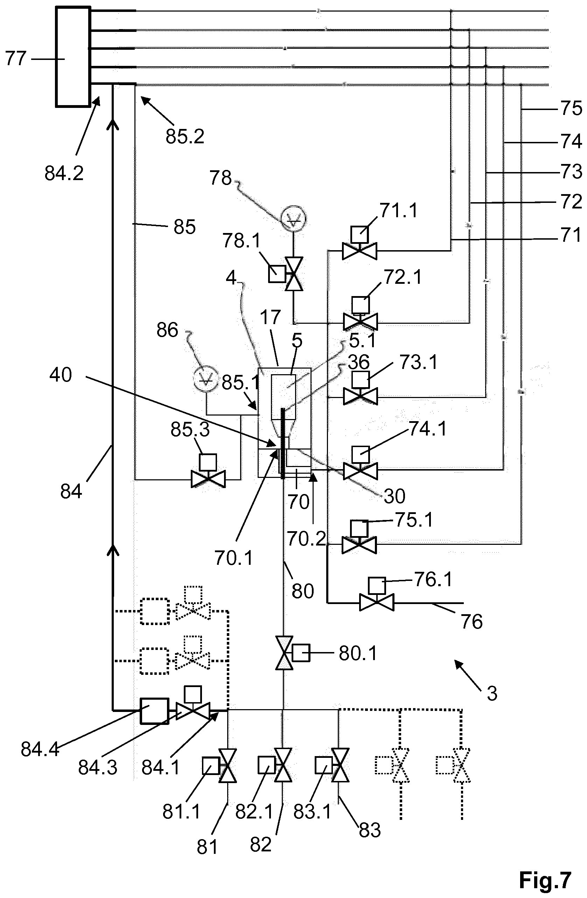

Figur 7 zeigt beispielhaft ein schematisches Blockschaltbild exemplarisch an einem Behandlungsplatz 40 einer Plasmastation 3, wie sie ein- oder mehrfach in einer Plasmakammer 17 gemäß einer der vorherigen Ausführungsformen angeordnet sein kann. In der Plasmakammer 17 wird im Kammerinnenraum 4 der Behälter 5 gas-und/oder luftdicht eingesetzt und positioniert. Vorliegend weist der Kammersockel 30 dabei, einen Vakuumkanal 70 aufs. Der Vakuumkanal 70 mündet dabei mit seiner ersten Seite 70.1 in der Plasmakammer 17 bzw. stellt je nach Stellung der Gaslanze 36 zusätzlich auch eine gasdurchlässige Verbindung in den Behälterinnenraum 5.1 des Behälters 5 her. Insbesondere kann vorgesehen sein, dass in einem in den Behälterinnenraum 5.1 eingefahrenen Zustand der Gaslanze 36 der Behälterinnenraum 5.1 gegenüber dem Kammerinnenraum 4 isoliert, d. h. abgedichtet, ist, wohingegen in einem abgesenkten Zustand der Gaslanze 36 eine gasdurchlässige Verbindung zwischen dem Behälterinnenraum 5.1 des Behälters 5 und dem Kammerinnenraum 4 geschaffen wird.

Ferner kann an einer zweiten Seite 70.2 des Vakuumkanals 70 wenigstens eine erste bis fünfte Vakuumleitung 71... 75 sowie wenigstens eine Belüftungsleitung 76 angeschlossen sein, wobei insbesondere die Belüftungsleitung 76 über eine regel-und/oder steuerbare Ventileinrichtung 76.1 zu- bzw. abschaltbar ausgebildet ist. Zudem kann auch jede der ersten bis fünften Vakuumleitungen 71...75 jeweils zumindest eine regel- und/oder steuerbare Ventileinrichtung 71.1...75.5 umfassen, wobei die Ventileinrichtungen 71.1...76.1 über eine nicht näher dargestellte Maschinensteuerung des Plasmamoduls 1 ansteuerbar ausgebildet sind.

An dem der zweiten Seite 70.2 des Vakuumkanals 70 abgewandten Ende stehen die erste bis fünfte Vakuumleitung 71...75 vorzugsweise mit einer für alle Vakuumleitungen 71...75 gemeinsamen Vakuumeinrichtung 77 in fluiddichter Verbindung. Die Vakuumeinrichtung 77 ist dabei insbesondere zur Erzeugung des in der Plasmakammer 17 sowie des Behälterinnenraums 5.1 während der Plasmabehandlung notwendigen Vakuums eingerichtet. Weiterhin ist Vakuumeinrichtung 77 dazu eingerichtet, an der ersten bis fünften Vakuumleitung 71...75 unterschiedliche Unterdrücke, also Unterdruckstufen je Vakuumleitung 71 ...75, zu erzeugen. Vorzugweise weist dabei die fünfte Vakuumleitung 75 einen gegenüber der ersten Vakuumleitung 71 größeren Unterdruck, also niedrigere Unterdruckstufe, auf. Insbesondere ist dabei vorgesehen, dass die Unterdruckstufen mit der jeder Vakuumleitung 71... 75 weiter erniedrigt werden, derart, dass in der fünften Vakuumleitung 75 die niedrigste Unterdruckstufe vorherrscht. Alternativ ist es jedoch auch möglich, die einzelnen Vakuumleitungen 71...75 an jeweils separate Vakuumeinrichtungen 77 anzuschließen.

Insbesondere kann vorgesehen sein, dass über die erste bis fünfte Vakuumleitung 71...75 die Plasmakammer 17 und/oder der Behälterinnenraum 5.1 auf unterschiedliche Unterdruckstufen abgesenkt werden. Beispielsweise kann hierfür angedacht sein, dass über die erste Vakuumleitung 71 bei geöffneter Ventileinrichtung 71.1 die Plasmakammer 17 einschließlich des Behälterinnenraums 5.1 auf eine erste Unterdruckstufe abgesenkt werden, während beispielsweise bei Öffnen der Ventileinrichtung 72.1 der zweiten Vakuumleitung 72 eine gegenüber der ersten Unterdruckstufe niedrigere Unterdruckstufe sowohl in der Plasmakammer 17 als auch in dem Behälterinnenraum 5.1 geschaffen wird. Weiterhin kann auch vorgesehen sein, dass beispielweise die fünfte Vakuumleitung 75 als Prozessvakuumleitung ausgebildet ist, die zur Aufrechterhaltung des Vakuums synchron zur Zuführung eines Prozessgases während der Plasmabehandlung geöffnet ist. Damit vermeidet die vorgesehene Prozessvakuumleitung einen Übertritt von abgesaugtem Prozessgas in die Versorgungskreise der weiteren Vakuumleitungen, beispielweise der ersten bis vierten Vakuumleitung 71 ...74.

Auch kann der ersten bis fünften Vakuumleitung 71...75 eine beispielweise als Druckmessröhre ausgebildete Druckmesseinrichtung 78 zugeordnet sein, die dazu eingerichtet ist, den über die erste bis fünfte Vakuumleitung 71 ...75 erzeugten Unterdruck zu erfassen. Insbesondere kann der Druckmesseinrichtung 78 eine vorgeschaltete Ventileinrichtung 78.1 zugeordnet sein und die Druckmesseinrichtung 78 in einer Fluidverbindung der zweiten Vakuumleitung 72 zur zweiten Seite 70.2 des Vakuumkanals 70 angeordnet werden.

Zudem kann die Gaslanze 36 über eine beispielweise zentrale Prozessgasleitung 80 mit beispielweise einer ersten bis dritten Prozessgasleitung 81 ...83 gekoppelt sein, über die jeweils unterschiedliche Prozessgaszusammensetzungen insbesondere dem Behälterinnenraum 5.1 mittels der Gaslanze 36 zuführbar sind. Eine jede der ersten bis dritten Prozessgasleitungen 81 ...83 kann dabei ferner jeweils zumindest eine beispielweise über die zentrale Maschinensteuerung des Plasmamoduls 1 regel-und/oder steuerbare Ventileinrichtung 81.1...83.1 aufweisen. Mithin kann auch die zentrale Prozessgasleitung 80 eine derartige steuer- und/oder regelbare Ventileinrichtung 80.1 umfassen.

Zudem ist vorzugsweise zwischen der Ventileinrichtung 80.1 der zentralen Prozessgasleitung 80 und den Ventileinrichtungen 81.1...83.1 der ersten bis dritten Prozessgasleitung 81...83 zumindest eine Bypassleitung 84 mit ihrer ersten Seite 84.1 fluiddicht abgezweigt, die mit ihrer zweiten Seite 84.2 ebenfalls fluiddicht in eine der ersten bis fünften Vakuumleitungen 71...75 einmündet. Die Bypassleitung 84 ist dabei dazu ausgebildet, bei einer Betriebsstörung der Plasmastation 3 bzw. des Behandlungsplatzes 3 das über die erste bis dritte Prozessgasleitung 81...83 anströmende Prozessgas vor dessen Zuführung in die Plasmakammer 17 dieser wenigstens einen, eine Betriebsstörung aufweisenden Behandlungsplatz 40 abzuleiten und zwar vorteilhafterweise in eine der ersten bis fünften Vakuumleitungen 71 ...75. Besonders vorteilhaft mündet die Bypassleitung 84 mit ihrer zweiten Seite 84.2 fluiddicht in die Vakuumleitung der zentralen Vakuumeinrichtung 77 mit der niedrigsten Unterdruckstufe, gemäß dem Ausführungsbeispiel der Figur 7 also in die fünfte Vakuumleitung 75. In einer alternativen Ausführungsvariante kann die Bypassleitung 84 auch in eine separate, nicht dargestellte, Vakuumeinrichtung fluiddicht einmünden.

Ferner umfasst die Bypassleitung 84 wenigstens eine über die zentrale Maschinensteuerung des Plasmamoduls 1 steuer- und/oder regelbare Ventileinrichtung 84.3 sowie mindestens eine steuer- und/oder regelbare Drosseleinrichtung 84.4 zur Durchflussdrosselung bzw. Begrenzung des durch die Bypassleitung 84 strömenden Volumenstroms an Prozessgas. Beispielweise kann die Drosseleinrichtung 84.4. als steuer- und/oder regelbarer Muffenschieber und damit insbesondere zur Begrenzung des durch die Bypassleitung 84 fließenden Volumenstroms an Prozessgas ausgebildet sein. Insbesondere ist die Drosseleinrichtung 84.4 der Ventileinrichtung 84.3 in der durch Pfeile kenntlich gemachten Strömungsrichtung nachgeschaltet in der Bypassleitung 84 vorgesehen.

Besonders vorteilhaft kann der Innenrohrquerschnitt der Bypassleitung 84 derart dimensioniert und/oder mittels der Drosseleinrichtung 84.4 eingestellt sein, dass der durch die Bypassleitung 84 abgeleitete Volumenstrom an Prozessgas näherungsweise dem Volumenstrom an Prozessgas entspricht, der über die zentrale Prozessgasleitung 80 der entsprechende Behandlungsplatz 3 während der Beaufschlagung mit Prozessgas zugeführt wird. In anderen Worten wird also der Innenrohrquerschnitt der Bypassleitung 84 derart gewählt bzw. mittels der Drosseleinrichtung 84.4 eingestellt, dass in der Bypassleitung 84 während des Ableitens des Prozessgases näherungsweise derselbe Vakuumleitwert in der Bypassleitung 84 wie in der zentralen Prozessgasleitung 80 während der Prozessgasbeaufschlagung für die Plasmabehandlung vorherrscht.

Weiterhin kann auch eine sechste Vakuumleitung 85 mit einer ersten Seite 85.1 unmittelbar und insbesondere fluiddicht mit der Plasmakammer 17 verbunden sein bzw. in diese einmünden, und mit einer zweiten Seite 85.2 unter Zwischenschaltung einer regel- und/oder steuerbaren Ventileinrichtung 85.3 über die fünfte Vakuumleitung 75 mit der zentralen Vakuumeinrichtung 77 fluiddicht zusammenwirken. Auch kann der sechsten Vakuumleitung 85 eine beispielsweise als Druckmessröhre ausgebildete Druckmesseinrichtung 86 zur Messung insbesondere des Unterdrucks innerhalb der Plasmakammer 17 zugeordnet sein.

Ein typischer Behandlungsvorgang an einem exemplarischen Behandlungsplatz 3 ohne Betriebsstörung wird im Folgenden am Beispiel eines Beschichtungsvorgangs erläutert, wobei das Verfahren zur Plasmabehandlung von Behältern 5 an einem mehrere Plasmastation 3 mit den jeweiligen Behandlungsplätzen 40 an einem Plasmarad 2 aufweisenden Plasmamoduls 1 erfolgt.

Dabei wird zunächst der jeweilige Behälter 5 unter Verwendung des Eingaberades zum Plasmarad 2 transportiert und in einem hochgeschobenen Zustand der hülsenartigen Kammerwandung 18 der Behälter 5 in die entsprechende Behandlungsplätze 3 eingesetzt. Nach einem Abschluss des Einsetzvorgangs wird die jeweilige Kammerwandung 18 an diesem Behandlungsplatz 3 in ihre abgedichtete Positionierung abgesenkt und zunächst gleichzeitig eine Evakuierung sowohl des Kammerinnenraumes 4 als auch des Behälterinnenraums 5.1 des Behälters 5 durchgeführt.

Nach einer ausreichenden Evakuierung des Kammerinnenraumes 4 wird die entsprechende Gaslanze 36 in den Behälterinnenraum 5.1 des Behälters 5 eingefahren und durch eine Verschiebung des Dichtelement 28 eine Abdichtung des Behälterinnenraums 5.1 gegenüber dem Kammerinnenraum 4 durchgeführt. Ebenfalls möglich, dass die Gaslanze 36 bereits synchron zur beginnenden Evakuierung des Kammerinnenraums 4 in den Behälter 5 hinein verfahren werden. Anschließend kann der Druck im Behälterinnenraum 5.1 noch weitergehend abgesenkt werden. Darüber hinaus ist auch daran gedacht, die Positionierbewegung der Gaslanze 36 wenigstens teilweise bereits parallel zur Positionierung der Kammerwandung 18 durchzuführen. Nach Erreichen eines ausreichend tiefen Unterdrucks wird Prozessgas in den Behälterinnenraum 5.1 des Behälters 5 an dem entsprechenden Behandlungsplatz 3 eingeleitet und mit Hilfe des Mikrowellengenerators 19 das Plasma gezündet. Insbesondere kann vorgesehen sein, dass mit Hilfe des Plasmas sowohl ein Haftvermittler auf eine innere Oberfläche des Behälters 5 als auch die eigentliche Barriere- und Schutzschicht aus Siliziumoxiden abgeschieden wird.

Nach einem Abschluss des Beschichtungsvorgangs, also der Plasmabehandlung, wird die Gaslanze 36 wieder aus dem Behälterinnenraum 5.1 entfernt, d. h. abgesenkt, und synchron oder dem Absenken der Gaslanze 36 zeitlich vorgelagert wenigstens der Behälterinnenraum 5.1 des Behälters 5 sowie ggfs. die Plasmakammer 17 wenigstens teilweise belüftet.

Unterliegt dabei wenigstens einer der Behandlungsplätze 3 einer Betriebsstörung, so wird zum Zeitpunkt der Einleitung bzw. Zuleitung des Prozessgases an bzw. in die entsprechende Plasmakammer 17 das Prozessgas dieses wenigstens einen Behandlungsplatzes 3, an der eine Betriebsstörung vorherrscht, mittels der Bypassleitung 84 abgeleitet. Dies führt dazu, dass an dem wenigstens einen weiteren Behandlungsplatz 3 des Plasmamoduls 1, an der keine Betriebsstörung vorherrscht und die sich zu diesem Zeitpunkt ebenfalls in demselben Verfahrensschritt des Beaufschlagens mittels Prozessgas befindet, kein Mehrdurchsatz an Prozessgas über die zentrale Prozessgasversorgungseinheit bereitgestellt wird. Dies deshalb, da der für den in einer Betriebsstörung befindlichen Behandlungsplatz 3 vorbestimmte Anteil bzw. Menge des Prozessgases über die Bypassleitung 84 abgeleitet wird. Somit kommt es an diesem wenigstens einen weiteren, im Betrieb befindlichen Behandlungsplatz 3 zu keiner Qualitätsbeeinträchtigung der Plasmabeschichtung, da die behandelten Behälter 5 mit der vorbestimmten Prozessgasmenge beaufschlagt wird. Da der wenigstens eine, eine Betriebsstörung aufweisende Behandlungsplatz 3 das anströmende Prozessgas mittels der Bypassleitung 84 abgeleitet wird, kann an den übrigen an dem Plasmamodul 1 vorgesehenen Plasmastation 3 oder deren Behandlungsplätzen 40 der Beschichtungsprozess mit gleichbleibend hoher Beschichtungsqualität betrieben bzw. vorgesetzt werden.

Zunächst wird nach einem Schließen der Plasmakammer 17 an wenigstens einer intakt arbeitenden, also keiner Betriebsstörung unterliegenden Plasmakammer 3 beispielsweise die erste und sechste Ventileinrichtung 71.1 bzw. 85.1 geöffnet und damit über die erste bzw. sechste Vakuumleitung 71 bzw. 85 sowohl der Behälterinnenraum 5.1 als auch der Innenraum der Plasmakammer 17 evakuiert. Bevorzugt ist während dessen die Ventileinrichtung 80.1 der zentralen Prozessgasleitung 80 geschlossen. Insbesondere ist während des Evakuierens des Behälterinnenraums 5.1 sowie der Plasmakammer 17 auch die Ventileinrichtung 76.1 der Belüftungsleitung 76 geschossen. Nach einem Schließen der ersten Ventileinrichtung 71.1 kann beispielweise die zweite Ventileinrichtung 72.1 geöffnet werden und damit der Behälterinnenraum 5.1 über die zweite Vakuumleitung 72 auf ein niedrigeres Druckniveau abgesenkt werden. Auch kann der Behälterinnenraum 5.1 und/oder die Plasmakammer 17 noch über die dritte oder vierte Vakuumleitung 73, 74 auf weitergehend niedrigere Unterdruckstufen abgesenkt werden, wenn dies erforderlich für den Beschichtungsprozess ist. Nach Erreichen eines ausreichend tiefen Druckniveaus in dem Behälterinnenraum 5.1 und/oder der Plasmakammer 17 können die entsprechenden Ventileinrichtungen 71.1...75.1 geschlossen werden. Alternativ kann auch vorgesehen sein, dass zur Bereitstellung eines weitergehend ausreichend tiefen Druckniveaus im Behälterinnenraum 5.1 und der Plasmakammer 17 während der nachfolgenden Behandlungsschritte insbesondere die fünfte Ventileinrichtung 75.1 sowie die sechste Ventileinrichtung 85.3 geöffnet bleiben.

Dabei kann an der wenigstens einen intakt arbeitenden Plasmakammer 3 gleichzeitig oder zeitlich vorgelagert zu einer Positionierung der Gaslanze 36 innerhalb des Behälterinnenraums 5.1 bereits eine oder mehrere der ersten bis dritten Ventileinrichtungen 81.1...83.1 der ersten bis dritten Prozessgasleitungen 81...83 sowie die Ventileinrichtung 80.1 der zentralen Prozessgasleitung 80 geöffnet werden und ein Prozessgas einer vorbestimmten Zusammensetzung und einer vorbestimmten Gasmenge insbesondere dem Behälterinnenraum 5.1 über die Gaslanze 36 zugeführt werden.

Weiterhin wird auch an der wenigstens einen, eine Betriebsstörung aufweisenden Plasmakammer 3 in der vorbestimmten zeitlichen Taktung im Vergleich zu den übrigen, an dem Plasmamodul 1 vorgesehenen Plasmakammern 3 eine oder mehrere der ersten bis dritten Ventileinrichtungen 81.1...83.1 der ersten bis dritten Prozessgasleitungen 81...83 geöffnet, während jedoch die Ventileinrichtung 80.1der zentralen Prozessgasleitung 80 dieser einen, eine Betriebsstörung aufweisenden Behandlungsplatz 3 geschlossen ist, wodurch ein Einströmen des Prozessgases in die entsprechende Plasmakammer 17 nicht möglich wird. Damit wird dem wenigstens eine, eine Betriebsstörung aufweisenden Behandlungsplatz 3 eine Prozessgasmenge zugeleitet, die der für diesen Behandlungsplatz 3 im intakt arbeitenden Betrieb vorbestimmten Prozessgasmenge entspricht.

Besonders bevorzugt wird zu dem Zeitpunkt des Öffnens einer oder mehrerer der ersten bis dritten Ventileinrichtungen 81.1...83.1 der ersten bis dritten Prozessgasleitungen 81 ...83 der wenigstens einen, eine Betriebsstörung aufweisenden Plasmastation 3 zeitgleich oder zeitlich kurz vorgelagert die Ventileinrichtung 84.3 geöffnet und das Prozessgas über die Bypassleitung 84 abgeleitet.

Insbesondere ist bei der wenigstens einen, eine Betriebsstörung aufweisenden Plasmastation 3 zum Zeitpunkt des Öffnens der Ventileinrichtung 84.3 der Bypassleitung 84 die Ventileinrichtung 80.4 der zentralen Prozessgasleitung 80 geschlossen, derart, dass das über die zentrale Prozessgasversorgungseinheit bereitgestellte Prozessgas über die Bypassleitung 84 der zentralen Vakuumeinrichtung 77 zugeführt wird. Insbesondere wird das Prozessgas dabei über fünfte Vakuumleitung 75 ausgeschleust. Insbesondere kann das Prozessgas über den im Zentrum des Plasmarades 2 vorgesehenen Drehverteiler 20 an die Plasmastationen 3 bzw. den jeweiligen Behandlungsplatz 40 geleitet werden, wobei die eigentliche Prozessgasverteilung über die Ringleitungen 21 erfolgen kann.

Nach einer ausreichenden Prozessgaszuführung zündet der Mikrowellengenerator 19 das Plasma im Behälterinnenraum 5.1 des Behälters 5. In diesem Zusammenhang kann vorgesehen sein, dass beispielsweise die Ventileinrichtung 81.1 der ersten Prozessgasleitung 81 zu einem vorgebaren Zeitpunkt schließt, während die Ventileinrichtung 82.1 der zweiten Prozessgasleitung 82 zur Zuführung eines Prozessgases einer zweiten Zusammensetzung geöffnet wird. Zumindest zeitweise kann dabei auch die fünfte Ventileinrichtung 75.1 und/oder die sechste Ventileinrichtung 85.3 geöffnet sein, um einen ausreichend niedrigen Unterdruck insbesondere im Behälterinnenraum 5.1 und/oder der Prozesskammer 17 aufrecht zu halten. Hierbei erweist sich ein Druckniveau von ca. 0,3 mbar als zweckmäßig.

Nach Abschluss der Plasmabehandlung werden die Ventileinrichtungen 81.1...83.1 der ersten bis dritten Prozessgasleitung 81...83 sowie sämtliche zu diesem Zeitpunkt noch geöffneten Ventileinrichtungen 71.1 ...75.1, 85.3 der ersten bis sechsten Vakuumleitung 71...75, 85 geschlossen, während die Ventileinrichtung 76.1 der Belüftungsleitung 76 geöffnet und zumindest der Behälterinnenraum 5.1 des Behälters 5 nach der Plasmabehandlung an dem wenigsten einen Behandlungsplatz 40 der Plasmastation 3 wenigstens teilweise belüftet wird. Vorzugsweise wird der Behälterinnenraum 5.1 des Behälters 5 dabei bis auf Atmosphärendruck belüftet.

Bevorzugt erfolgt dabei die Belüftung über die Gaslanze 36 in dem Behälterinnenraum 5.1. Synchron dazu kann die Gaslanze 36 aus dem Behälterinnenraum 5.1 abgesenkt werden. Nach einer ausreichenden Belüftung des Behälterinnenraums 5.1 und der Plasmakammer 17 bis auf vorzugsweise Atmosphärendruck, bzw. Umgebungsdruck wird die geöffnete Ventileinrichtung 76.1 der Belüftungsleitung 76 geschlossen. Dabei beträgt die Belüftungszeit je Behälter 5 zwischen 0,1 und 0,4 Sekunden, vorzugsweise etwa 0,2 Sekunden. Nach Erreichen des Umgebungsdruckes innerhalb der Kammerinnenraum 4 wird die Kammerwandung 18 wieder angehoben. Nachfolgend erfolgt eine Entnahme bzw. Übergabe des beschichteten Behälters 5 an das Ausgaberad 12.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrunde liegende Erfindungsgedanke verlassen wird.

### Bezugszeichenliste

- 1: Plasmamodul
- 2: Plasmarad
- 3: Plasmastation
- 4: Kammerinnenraum
- 5: Behälter
- 5.1: Behälterinnenraum
- 6: Eingabe
- 7: Vereinzelungsrad
- 8: Übergaberad
- 9: Tragarm
- 10: Sockel
- 11: Eingaberad
- 12: Ausgaberad
- 13: Ausgabestrecke
- 14: Tragring
- 15: Maschinensockel
- 16: Stationsrahmen
- 17: Plasmakammer
- 18: Kammerwandung
- 19: Mikrowellengenerator
- 20: Drehverteiler
- 21: Ringleitung
- 23: Führungsstange
- 24: Schlitten
- 25: Umlenkung
- 26: Adapter
- 27: Kopplungskanal
- 28: Halteelement
- 29: Kammerboden
- 30: Kammersockel
- 31: Kammerdeckel
- 32: Flansch
- 33: Dichtung
- 34: Innenflansch
- 35: Dichtung
- 36: Gaslanze
- 37: Lanzenschlitten
- 38: Prozessgaskanal
- 39: Gasanschluss
- 40: Behandlungsplatz
- 70: Vakuumkanal
- 70.1: erste Seite
- 70.2: zweite Seite
- 71: erste Vakuumleitung
- 71.1: Ventileinrichtung
- 72: zweite Vakuumleitung
- 72.1: Ventileinrichtung
- 73: dritte Vakuumleitung
- 73.1: Ventileinrichtung
- 74: vierte Vakuumleitung
- 74.1: Ventileinrichtung
- 75: fünfte Vakuumleitung
- 75.1: Ventileinrichtung
- 76: Belüftungsleitung
- 76.1: Ventileinrichtung
- 77: Vakuumeinrichtung
- 78: Druckmesseinrichtung
- 78.1: Ventileinrichtung
- 80: zentrale Prozessgasleitung
- 80.1: Ventileinrichtung
- 81: erste Prozessgasleitung
- 81.1: Ventileinrichtung
- 82: zweite Prozessgasleitung
- 82.2: Ventileinrichtung
- 83: dritte Prozessgasleitung
- 83.1: Ventileinrichtung
- 84: Bypassleitung
- 84.1: erste Seite
- 84.2: zweite Seite
- 84.3: Ventileinrichtung
- 84.4: Drosseleinrichtung
- 85: sechste Vakuumleitung
- 85.1: erste Seite
- 85.2: zweite Seite
- 85.3: Ventileinrichtung
- 86: Druckmesseinrichtung

## Patentansprüche

1. Verfahren zur Plasmabehandlung von Behältern (5) mittels eines mehrere Plasmastationen (3) an einem Plasmarad (2) aufweisenden Plasmamoduls (1), wobei jede Plasmastation (3) mindestens eine Plasmakammer (17) mit mindestens einen Behandlungsplatz (40) umfasst, mit den Schritten:
▪ Einsetzten und Positionieren mindestens eines Behälters (5) mit einem Behälterinnenraum (5.1) in die Plasmakammer (17) auf den Behandlungsplatz (40) einer entsprechenden Plasmastation (3),
▪ Zumindest teilweises Evakuieren der jeweiligen Plasmakammer (17) und des mindestens einen Behälterinnenraums (5.1),
▪ Zumindest teilweises Beaufschlagen des Behälterinnenraums (5.1) innerhalb der zumindest teilweise evakuierten Plasmakammer (17) mit einem Prozessgas, wobei das zumindest teilweise Beaufschlagen an zumindest einer Plasmastationen (3) durch eine zentrale Prozessgasversorgung gleichzeitig erfolgt,
▪ Versehen zumindest des Behälterinnenraums (5.1) mit einer Innenbeschichtung mittels Plasmabehandlung, und
▪ Durchführen eines Belüftungsschrittes nach der Plasmabehandlung, bei welchem sowohl die Plasmakammer (17) als auch der mindestens eine Behälterinnenraum (5.1) des Behälters (5) zumindest teilweise belüftet werden,
**dadurch gekennzeichnet, dass**
bei einer Betriebsstörung und/oder Ausblendung in wenigstens einem Behandlungsplatz (40) einer der Plasmastationen (3) das Prozessgas vor dessen Zuführung zu dem Behandlungsplatz (40) und/oder den dort gehaltenen Behälter (5) mindestens teilweise, insbesondere aber vollständig mittels einer Bypassleitung (84) abgeleitet wird.

2. Verfahren nach Anspruch 1, **dadurch gekennzeichnet, dass** an dem wenigstens einen, eine Betriebsstörung aufweisenden und/oder ausgeblendeten Behandlungsplatz (3) eine Prozessgasmenge abgeleitet wird, die der für diese Behandlungsplatz (3) im intakt arbeitenden Betrieb vorbestimmten Prozessgasmenge entspricht.

3. Verfahren nach einem der Ansprüche 1 oder 2, **dadurch gekennzeichnet, dass** bei einer Betriebsstörung und/oder Ausblendung für mindestens eine gesamte Plasmastation (3) mit allen ihren Behandlungsplätzen (40) das Prozessgas vor dessen Zuführung abgeleitet wird.

4. Verfahren nach einem der Ansprüch 1 bis 3, **dadurch gekennzeichnet, dass** das Prozessgas in der Bypassleitung (84) mittels zumindest einer Ventileinrichtung (84.3) und/oder einer Drosseleinrichtung (84.4) geregelt und/oder gesteuert abgeleitet wird.

5. Verfahren nach Anspruch 4, **dadurch gekennzeichnet, dass** mittels der Drosseleinrichtung (84.4) der Volumenstrom des abgeleiteten Prozessgases in der Bypassleitung (84) geregelt und/oder gesteuert abgeleitet wird.

6. Verfahren nach Anspruch 4 oder 5, **dadurch gekennzeichnet, dass** die Drosseleinrichtung (84.4) der Bypassleitung (84) des wenigstens einen, eine Betriebsstörung aufweisenden und/oder ausgeblendeten Behandlungsplatz (3) derart gesteuert und/oder geregelt wird, dass der über die Bypassleitung (84) abgeleitete Volumenstrom an Prozessgas dem Volumenstrom an Prozessgas entspricht, mit dem die wenigstens eine, eine Betriebsstörung aufweisende und/oder ausgeblendeten Behandlungsplatz (3) über eine oder mehrere weitere Ventileinrichtungen (81.1...83.1) beaufschlagt wird.

7. Verfahren nach Anspruch 6, **dadurch gekennzeichnet, dass** zu dem Zeitpunkt des Öffnens einer oder mehrerer Ventileinrichtungen (81.1...83.1) der wenigstens einen, eine Betriebsstörung aufweisenden und/oder ausgeblendeten Plasmakammer (3) zeitgleich oder zeitlich kurz vorgelagert die Ventileinrichtung (84.3) geöffnet und das Prozessgas über die Bypassleitung (84) abgeleitet wird.

8. Verfahren nach Anspruch 6 oder 7, **dadurch gekennzeichnet, dass** das Prozessgas in einer vorbestimmten Prozessgasmenge und/oder zeitlichen Taktung an die zumindest eine, eine Betriebsstörung aufweisende Behandlungsplatz (3) über eine oder mehrerer Prozessgasleitung (81...83...) einer zentralen Prozessgasversorgungseinheit abgeleitet wird.

9. Verfahren nach einem der vorhergehenden Ansprüche, **dadurch gekennzeichnet, dass** das Prozessgas der zumindest einen, eine Betriebsstörung aufweisenden Behandlungsplatz (3) mittels der Bypassleitung (84) in eine zentrale Vakuumeinrichtung (77) abgeleitet wird.

10. Verfahren nach Anspruch 9, **dadurch gekennzeichnet, dass** das Prozessgas der zumindest einen, eine Betriebsstörung aufweisenden und/oder ausgeblendeten Behandlungsplatz (3) mittels der Bypassleitung (84) in eine Vakuumleitung (71 ...75) mit der zum Pumpen prozessgastauglichen Unterdruckstufe der zentralen Vakuumeinrichtung (77) abgeleitet wird.

11. Vorrichtung zur Plasmabehandlung von Behältern (5), umfassend mehrere an einem Plasmarad (2) angeordnete Plasmastationen (3), wobei jede Plasmastation (3) mindestens eine Plasmakammer (17) mit mindestens einen Behandlungsplatz (40) umfasst, in welcher mindestens ein Behälter (5) mit einem Behälterinnenraum (5.1) an dem Behandlungsplatz (40) einsetzbar und positionierbar ist, wobei die jeweilige Plasmakammer (17) zumindest teilweise evakuierbar ausgebildet ist, wobei die Plasmastationen (3) dazu eingerichtet sind, den zumindest einen Behälterinnenraum (5.1) des jeweiligen Behälters (5) zumindest teilweise mit einem Prozessgas zu beaufschlagen, derart, dass das zumindest teilweise Beaufschlagen an zumindest zwei Behandlungsplätzen (40) gleichzeitig erfolgt, wobei die Plasmastationen (3) dazu eingerichtet sind, zumindest den Behälterinnenraum (5) innerhalb der zumindest teilweise evakuierten Plasmakammer (17) eine Innenbeschichtung mittels Plasmabehandlung auszubilden und wobei die Plasmastationen (3) wenigstens eine Belüftungsleitung (76) zum zumindest teilweisen Belüften sowohl der Plasmakammer (17) als auch des zumindest einen Behälterinnenraumes (5.1) über den Behandlungsplatz (40) nach der Plasmabehandlung aufweisen, **dadurch gekennzeichnet, dass** die Plasmastationen (3) jeweils mindestens eine Bypassleitung (84) aufweisen, so dass bei einer Betriebsstörung und/oder Ausblendung wenigstens einer der Behandlungsplätze (40) der Plasmastationen (3) das Prozessgas vor dessen Zuführung in die Plasmakammer (17) und/oder an den Behandlungsplatz (40) mittels der einen oder mehreren Bypassleitungen (84) ableitbar ist.

12. Vorrichtung nach Anspruch 11, **dadurch gekennzeichnet, dass** ein erstes Ende (84.1) der Bypassleitung (84) fluiddicht in eine zentrale Prozessgasleitung (80) einmündet und ein zweites Endes (84.2) fluiddicht in eine zentrale Vakuumeinrichtung (77).

13. Vorrichtung nach Anspruch 11 oder 12, **dadurch gekennzeichnet, dass** die Bypassleitung (84) wenigstens eine regel- und/oder steuerbare Ventileinrichtung (84.3) sowie eine Drosseleinrichtung (84.4) aufweist.

14. Vorrichtung nach einem des Ansprüche 11 bis 13, **dadurch gekennzeichnet, dass** die Bypassleitung (84) einen Vakuumleitwert ausbildet, der näherungsweise dem Vakuumleitwert einer Prozessgasleitung (80) entspricht.

## Claims

1. Method for plasma treatment of containers (5) by means of a plasma module (1) having several plasma stations (3) on a plasma wheel (2), wherein each plasma station (3) comprises at least one plasma chamber (17) with at least one treatment point (40), with the steps of:
▪ inserting and positioning at least one container (5) with a container interior (5.1) in the plasma chamber (17) on the treatment point (40) of a corresponding plasma station (3),
▪ at least partially evacuating the respective plasma chamber (17) and the at least one container interior (5.1),
▪ at least partially charging the container interior (5.1) inside the at least partially evacuated plasma chamber (17) with a process gas, wherein the at least partial charging is effected at the same time at least at one plasma station (3) through a central process gas feed,
▪ providing at least the container interior (5.1) with an inner coating by means of plasma treatment, and
▪ carrying out a ventilation step after the plasma treatment, in which both the plasma chamber (17) and the at least one container interior (5.1) of the container (5) are at least partially ventilated,
**characterized in that**
in the case of an operational malfunction and/or a cut-out in at least one treatment point (40) of one of the plasma stations (3) the process gas is at least partially, but in particular completely, discharged by means of a bypass line (84) before being supplied to the treatment point (40) and/or the container (5) held there.

2. Method according to claim 1, **characterized in that** a quantity of process gas which corresponds to the quantity of process gas predetermined for this treatment point (3) during faultless operation is discharged at the at least one treatment point (3) having an operational malfunction and/or cut-out.

3. Method according to one of claims 1 or 2, **characterized in that** in the case of an operational malfunction and/or cut-out for at least one entire plasma station (3) with all of its treatment points (40) the process gas is discharged before being supplied.

4. Method according to one of claims 1 to 3, **characterized in that** the process gas is discharged in a regulated and/or controlled manner in the bypass line (84) by means of at least one valve device (84.3) and/or restrictor device (84.4).

5. Method according to claim 4, **characterized in that** the volume flow of the discharged process gas is discharged in a regulated and/or controlled manner in the bypass line (84) by means of the restrictor device (84.4).

6. Method according to claim 4 or 5, **characterized in that** the restrictor device (84.4) of the bypass line (84) of the at least one treatment point (3) having an operational malfunction and/or cut-out is controlled and/or regulated in such a way that the volume flow of process gas discharged via the bypass line (84) corresponds to the volume flow of process gas with which the at least one treatment point (3) having an operational malfunction and/or cut-out is charged via one or more further valve devices (81.1...83.1).

7. Method according to claim 6, **characterized in that** at the time when one or more valve devices (81.1...83.1) of the at least one plasma chamber (3) having an operational malfunction and/or cut-out are opened, the valve device (84.3) is opened at the same time or shortly beforehand and the process gas is discharged via the bypass line (84).

8. Method according to claim 6 or 7, **characterized in that** the process gas is discharged in a predetermined quantity of process gas and/or in timed sequence to the at least one treatment point (3) having an operational malfunction via one or more process gas lines (81...83...) of a central process gas feed unit.

9. Method according to one of the preceding claims, **characterized in that** the process gas of the at least one treatment point (3) having an operational malfunction is discharged into a central vacuum device (77) by means of the bypass line (84).

10. Method according to claim 9, **characterized in that** the process gas of the at least one treatment point (3) having an operational malfunction and/or cut-out is discharged by means of the bypass line (84) into a vacuum line (71...75) with the negative pressure level capable of pumping process gas of the central vacuum device (77).

11. Device for plasma treatment of containers (5), comprising several plasma stations (3) arranged on a plasma wheel (2), wherein each plasma station (3) comprises at least one plasma chamber (17) with at least one treatment point (40), in which at least one container (5) with a container interior (5.1) can be inserted and positioned on the treatment point (40), wherein the respective plasma chamber (17) is formed at least partially evacuable, wherein the plasma stations (3) are set up to charge the at least one container interior (5.1) of the respective container (5) at least partially with a process gas, in such a way that the at least partial charging is effected at least at two treatment points (40) at the same time, wherein the plasma stations (3) are set up to form an inner coating on at least the container interior (5) inside the at least partially evacuated plasma chamber (17) by means of plasma treatment and wherein the plasma stations (3) have at least one ventilation line (76) for at least partially ventilating both the plasma chamber (17) and the at least one container interior (5.1) via the treatment point (40) after the plasma treatment, **characterized in that** the plasma stations (3) have in each case at least one bypass line (84), with the result that in the case of an operational malfunction and/or cut-out of at least one of the treatment points (40) of the plasma stations (3) the process gas can be discharged by means of the one or more bypass lines (84) before being supplied into the plasma chamber (17) and/or to the treatment point (40).

12. Device according to claim 11, **characterized in that** a first end (84.1) of the bypass line (84) flows in a fluid-tight manner into a central process gas line (80) and a second end (84.2) flows in a fluid-tight manner into a central vacuum device (77).

13. Device according to claim 11 or 12, **characterized in that** the bypass line (84) has at least one regulatable and/or controllable valve device (84.3) as well as a restrictor device (84.4).

14. Device according to one of claims 11 to 13, **characterized in that** the bypass line (84) forms a vacuum conductance which approximately corresponds to the vacuum conductance of a process gas line (80).

## Revendications

1. Procédé de traitement par plasma de récipients (5) à l'aide d'un module de plasma (1) comportant plusieurs stations de plasma (3) au niveau d'une roue plasmique (2) ;
chaque station de plasma (3) comprenant au moins une chambre de plasma (17) avec au moins un site de traitement (40), avec les étapes suivantes :
- insertion et positionnement d'au moins un récipient (5) avec un espace intérieur de récipient (5.1) dans la chambre de plasma (17) sur le site de traitement (40) d'une station de plasma (3) correspondante ;
- évacuation au moins partielle de la chambre de plasma (17) respective et de l'au moins un espace intérieur de récipient (5.1) ;
- alimentation au moins partielle de l'espace intérieur de récipient (5.1) à l'intérieur de la chambre de plasma (17) au moins en partie évacuée avec un gaz de traitement, l'alimentation au moins partielle étant réalisée simultanément au niveau d'au moins une des stations de plasma (3) par une alimentation en gaz de traitement centrale ;
- mise à disposition d'un revêtement intérieur par traitement par plasma pour au moins l'espace intérieur de récipient (5.1) ; et
- réalisation d'une étape d'aération après le traitement par plasma au cours de laquelle tant la chambre de plasma (17) que l'au moins un espace intérieur de récipient (5.1) du récipient (5) sont aérés au moins en partie ;
**caractérisé en ce que** :
en cas de dysfonctionnement et/ou de collimation dans au moins un site de traitement (40) d'une des stations de plasma (3), le gaz de traitement est dérivé avant son amenée vers le site de traitement (40) et/ou les récipients (5) s'y trouvant, au moins en partie, notamment entièrement, à l'aide d'une conduite de dérivation (84).

2. Procédé selon la revendication 1, **caractérisé en ce qu'**une quantité de gaz de traitement est dérivée au niveau de l'au moins un site de traitement (3) collimaté ou présentant au moins un dysfonctionnement, ladite quantité correspondant à la quantité de gaz de traitement prédéfinie pour ce site de traitement (3) en fonctionnement de travail intact.

3. Procédé selon l'une quelconque des revendications 1 ou 2, **caractérisé en ce qu'**en cas de dysfonctionnement et/ou de collimation pour au moins une station de plasma (3) totale avec tous ses sites de traitement (40), le gaz de traitement est dérivé avant son amenée.

4. Procédé selon l'une quelconque des revendications 1 à 3, **caractérisé en ce que** le gaz de traitement est dérivé de façon réglée et/ou commandée dans la conduite de dérivation (84) à l'aide d'au moins un dispositif de soupape (84.3) et/ou d'un dispositif d'étranglement (84.4).

5. Procédé selon la revendication 4, **caractérisé en ce que** le débit volumique du gaz de traitement dérivé est dérivé de façon réglée et/ou commandée dans la conduite de dérivation (84)à l'aide du dispositif d'étranglement (84.4).

6. Procédé selon la revendication 4 ou 5, **caractérisé en ce que** le dispositif d'étranglement (84.4) de la conduite de dérivation (84) de l'au moins un site de traitement (3) collimaté et/ou présentant un dysfonctionnement est réglé et/ou commandé de telle sorte que le débit volumique de gaz de traitement dérivé via la conduite de dérivation (84) corresponde au débit volumique de gaz de traitement avec lequel l'au moins un site de traitement (3) collimaté et/ou présentant un dysfonctionnement est amené via un ou plusieurs dispositifs de soupape (81.1 ...83.1) supplémentaires.

7. Procédé selon la revendication 6, **caractérisé en ce qu'**à l'instant de l'ouverture d'un ou de plusieurs dispositifs de soupape (81.1 ...83.1) de l'au moins une chambre de plasma (3) collimatée et/ou présentant un dysfonctionnement, le dispositif de soupape (84.3) est ouvert en même temps ou peu de temps avant et que le gaz de traitement est dérivé via la conduite de dérivation (84).

8. Procédé selon la revendication 6 ou 7, **caractérisé en ce que** le gaz de traitement est évacué dans une quantité de gaz de traitement et/ou à une cadence prédéfinie au niveau de l'au moins un site de traitement (3) présentant un dysfonctionnement via une ou plusieurs conduites de gaz de traitement (81 ...83...) d'une unité d'alimentation en gaz de traitement centrale.

9. Procédé selon l'une quelconque des revendications précédentes, **caractérisé en ce que** le gaz de traitement de l'au moins un site de traitement (3) présentant un dysfonctionnement est dérivé dans un dispositif de vide central (77) à l'aide de la conduite de dérivation (84).

10. Procédé selon la revendication 9, **caractérisé en ce que** le gaz de traitement de l'au moins un site de traitement (3) collimaté et/ou présentant un dysfonctionnement est dérivé dans une conduite de vide (71 ...75) à l'aide de la conduite de dérivation (84), avec le niveau de sous-pression du dispositif de vide central (77) adapté aux pompes de gaz de traitement.

11. Dispositif de traitement par plasma de récipients (5), comprenant plusieurs stations de plasma (3) disposées au niveau d'une roue plasmique (2), chaque station de plasma (3) comprenant au moins une chambre de plasma (17) avec au moins un site de traitement (40) dans lequel au moins un récipient (5) avec un espace intérieur de récipient (5.1) peut être inséré et positionné au niveau du site de traitement (40), la chambre de plasma (17) respective étant réalisée de façon à pouvoir être évacuée au moins en partie, les stations de plasma (3) étant conçues pour amener un gaz de traitement au moins en partie dans l'au moins un espace intérieur de récipient (5.1) du récipient (5) respectif, de telle sorte que l'alimentation soit réalisée au moins en partie simultanément au niveau d'au moins deux sites de traitement (40), les stations de plasma (3) étant conçues pour former un revêtement intérieur dans au moins l'espace intérieur de récipient (5) à l'intérieur de la chambre de plasma (17) évacuée au moins en partie à l'aide du traitement par plasma et les stations de plasma (3) comportant au moins une conduite d'aération (76) pour aérer au moins en partie tant la chambre de plasma (17) que l'au moins un espace intérieur de récipient (5.1) via le site de traitement (40) après le traitement par plasma, **caractérisé en ce que** les stations de plasma (3) comportent respectivement au moins une conduite de dérivation (84), de sorte qu'en cas de dysfonctionnement et/ou de collimation d'au moins un des sites de traitement (40) des stations de plasma (3), le gaz de traitement peut être dérivé avant son amenée dans la chambre de plasma (17) et/ou au niveau du site de traitement (40) à l'aide de la ou des conduites de dérivation (84).

12. Dispositif selon la revendication 11, **caractérisé en ce qu'**une première extrémité (84.1) de la conduite de dérivation (84) débouche, de manière étanche aux fluides, dans une conduite de gaz de traitement (80) central et qu'une deuxième extrémité (84.2) débouche, de manière étanche aux fluides, dans un dispositif de vide central (77).

13. Dispositif selon la revendication 11 ou 12, **caractérisé en ce que** la conduite de dérivation (84) comporte au moins un dispositif de soupape (84.3) réglable et/ou commandable ainsi qu'un dispositif d'étranglement (84.4).

14. Dispositif selon l'une quelconque des revendications 11 à 13, **caractérisé en ce que** la conduite de dérivation (84) forme une valeur de conduction de vide correspondant approximativement à la valeur de conduction de vide d'une conduite de gaz de traitement (80).
